Europäisches Patentamt

European Patent Office

Office européen des brevets

(11) Publication number: **0 137 914**
A2

## (12) EUROPEAN PATENT APPLICATION

(21) Application number: **84107432.1**

(22) Date of filing: **28.06.84**

(51) Int. Cl.⁴: **H 01 L 21/322, H 01 L 21/324**

(30) Priority: **02.09.83 US 528816**

(43) Date of publication of application: **24.04.85**
Bulletin **85/17**

(84) Designated Contracting States: **DE FR GB**

(71) Applicant: **International Business Machines Corporation, Old Orchard Road, Armonk, N.Y. 10504 (US)**

(72) Inventor: **Case, Stephen William, 24 Liberty Street, Newburgh New York 12 550 (US)**
Inventor: **Mendel, Eric, 3 High Point Drive, Poughkeepsie New York 12 603 (US)**
Inventor: **Pak, Mun Sok, 5-7 Maloney Road, Poughkeepsie New York 12 603 (US)**
Inventor: **Patzner, Eugene Joseph, Brusk Drive, Hopewell Junction New York 12 533 (US)**
Inventor: **Wilson, Leon Gardner, Jr., 19 Horseshoe Drive, Danbury Connecticut 06 810 (US)**

(74) Representative: **Gaugel, Heinz, Dipl.-Ing., Schönaicher Strasse 220, D-7030 Böblingen (DE)**

(54) Silicon wafers for integrated circuit chip fabrication.

(57) Warpage of silicon wafers, due to heat cycle processing for bipolar wafers, is minimized by selecting wafer thicknesses in accordance with a special, substantially linear plot of wafer thicknesses as a function of wafer diameter. Selection of wafer thickness, in accordance with the present invention, also enhances leakage limited yield of the processed wafers and eliminates the need for oxygen screening of the wafers.

## SILICON WAFERS FOR INTEGRATED CIRCUIT CHIP FABRICATION

This invention generally relates to silicon wafer heat cycle processing for bipolar transistors and, more particularly to the selection of wafer parameters for the minimization of warpage resulting from said processing.

It is generally recognized that the warpage of silicon wafers, after being subjected to elevated temperature processing such as in the manufacture of bipolar transistor integrated circuits, is to be avoided to the extent possible so that photolithography-related steps may be carried out with the greatest precision and reproducibility for maximum component density and yield. One approach to the minimization of warpage has focused upon the relationship between warpage and the oxygen concentration in the silicon wafer. U.S. Patent 4,017,341 issued in the name of Takaya Suzuki, et al. on April 12, 1977, for example, discloses a passivation film method to prevent the diffusion or penetration of oxygen into polycrystalline portions of a wafer to reduce warpage. A related technique is to test and screen all incoming single crystal wafers to meet stringent oxygen concentration specifications before the wafers are accepted for heat processing. It is desirable, of course, that a way be found to solve the warpage problem without resort to such costly special precautions to monitor wafer oxygen concentration.

It has also been known that there is a relationship between silicon wafer diameter, thickness and propensity to deflection (when subjected to measured loads). In a paper "Semiconductor Wafer Flatness and Warpage" by F. Y. Chui et al., presented at the November 15-17,

FI 982 087

1976 annual meeting of the Materials Research Society of Cambridge, Massachusetts, a number of plotted data points (deflection versus wafer thickness) were presented for different diameter wafers, including 32.5 mm, 57 mm, 76 mm, 82.5 mm, 102 mm, and 128 mm wafers, subjected to loads of known weight. The data showed that the thicker the wafer, the less deflection. One might surmise from such data that a straightforward answer to the silicon wafer warpage problem is simply to increase wafer thickness until acceptably small warpage is achieved. However, arbitrary increases in wafer thickness not only is costly in terms of wasteful silicon usage but also may give rise to yield and other problems.

Current industry standards, reported by the Semiconductor Equipment and Materials Institute, Inc., specify a thickness of 254 to 305 $\mu$m for 50 mm wafers, 365 to 417 $\mu$m for 75 mm diameter wafers, 381 to 432 $\mu$m for 80 mm wafers, 457 to 508 $\mu$m for 90 mm wafers, 508 to 559 or 610 to 660 $\mu$m for 100 mm wafers, 610 to 660 $\mu$m for 125 mm wafers and 660 to 711 $\mu$m for 150 mm wafers. When using the specified thicknesses, it generally has been found necessary to carefully control or screen the silicon wafers to assure oxygen content in order to avoid objectionable wafer warpage after exposure to the elevated temperature cycling, of about 1000°C, associated with bipolar transistor processing. The testing, sorting and rejection of considerable portions of each silicon crystal ingot or the careful control of the crystal growth process as are required to meet such oxygen content specifications are costly procedures which should be eliminated wherever possible.

FI 982 087

0137914

The invention as claimed is intended to remedy these drawbacks. It solves the problem of how to optimally reduce silicon wafer warpage.

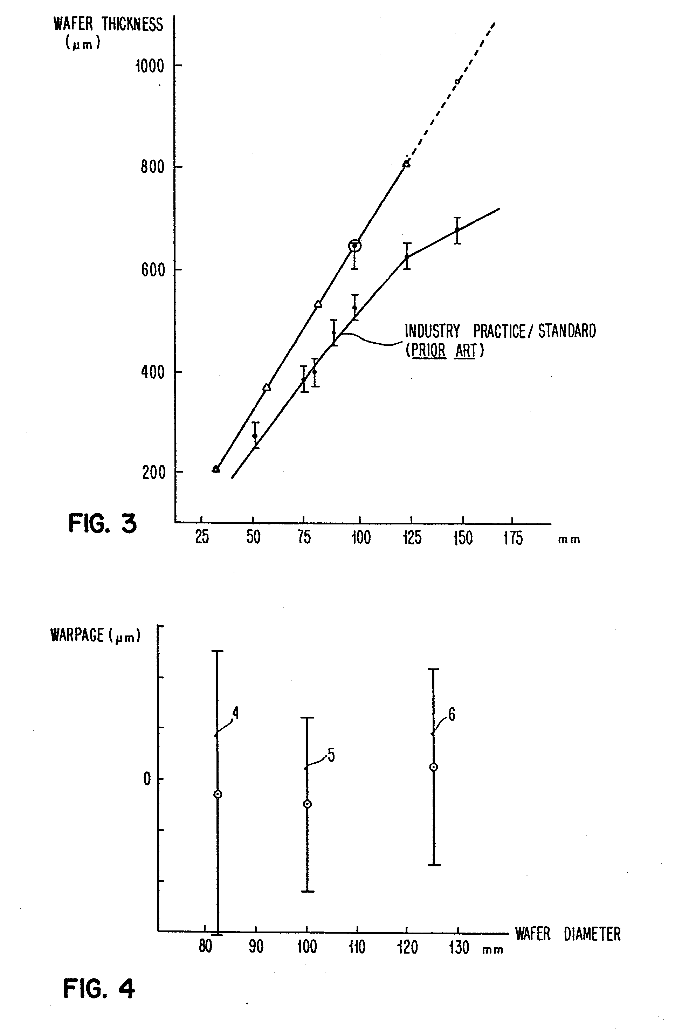

In summary, silicon wafers in excess of 50 mm in diameter and other than 100 mm in diameter, having a thickness in the range of substantially $\pm$ 25 µm centered about the values lying along the plot of Fig. 3, are used optimally to reduce wafer warpage as a result of wafer exposure to high temperature cycles of about 1000°C which are associated with bipolar transistor fabrication processing. The higher limit of the aforesaid range also enhances the leakage limited yield of the processed wafers. The use of the thickness range eliminates the need for oxygen screening.

The invention is described in detail with reference to drawings, in which:

Fig. 1      is a plot of leakage limited yield and warpage data obtained after completion of high temperature heat cycling of 82.5 mm diameter wafers of different thicknesses;

Fig. 2      is a plot of warpage data obtained after completion of heat cycling of 125 mm diameter wafers of different thicknesses;

Fig. 3      is a superimposed plot of optimum wafer thickness versus wafer diameter, in accordance with the present invention and wafer thickness versus wafer diameter as practiced in the prior art; and

FI 982 087

Fig. 4    is a plot of warpage spread data after
completion of heat cycling for wafers of
the same thickness having each of three
different diameters.

It has been found that at the conventional thickness
of 400 μm, wafers of 82.5 mm diameter having moderately
high (> 30 PPM) oxygen content warped and experienced
low leakage limited yield after completion of the heat
processing steps encountered in bipolar transistor integrated circuit processing. In order to avoid such
undesirable results, resort has been had to crystal
cropping and wafer sorting to meet strict oxygen content limits with concomitant loss of up to 50 % of
raw crystal ingot material.

In contrast with the industry practice, we have discovered that there is an optimum thickness for the
82.5 mm wafer (and optimum thicknesses as well for
other diameter wafers) of approximately 533 μm. This
optimum thickness is true for wafers derived from the
seed end and tail end as well as from the main body of
silicon crystal ingots. Use of the optimum thickness
was found to maximize leakage limited yield and to
minimize wafer warpage at the completion of the heat
processing of bipolar integrated circuit chips.

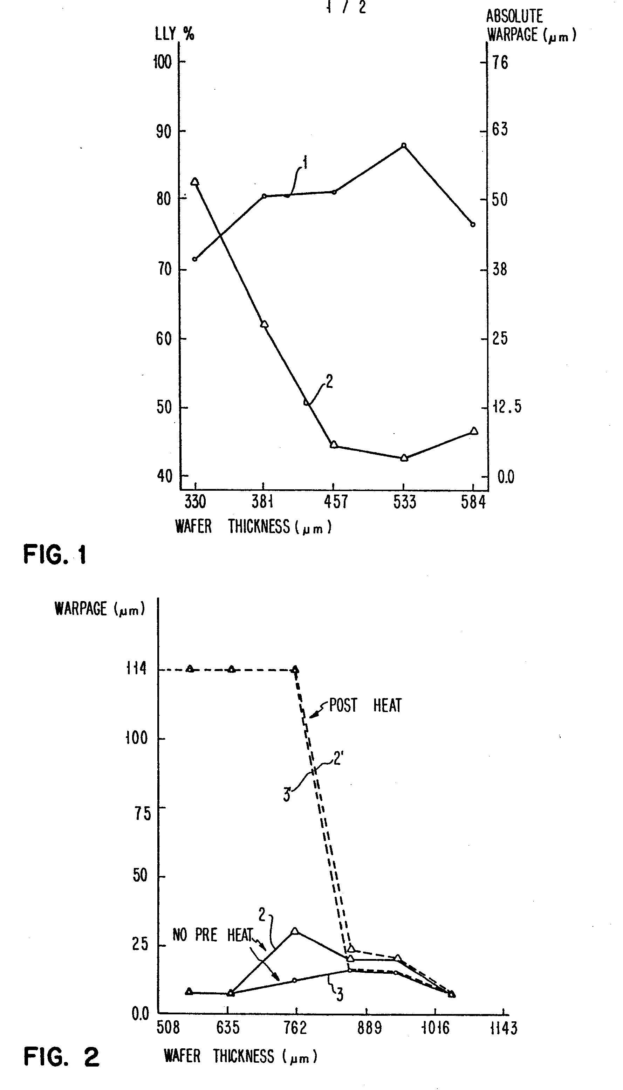

More particularly, a number of silicon wafers of different thicknesses but of the same 82.5 mm diameter
were subjected to the temperature-time cycles of state-
of-the-art bipolar integrated circuit chip processing.
The results are shown in Fig. 1. Curve 1 represents the
leakage limited yield experienced with wafers having
thicknesses of 330, 381, 457, 533 and 584 μm. Warpage

of the same wafers is represented by curve 2. It will be noted that a maximum in curve 1 coincides with a minimum in curve 2 at the 533 μm wafer thickness.

Similar tests were run using 125 mm diameter silicon wafers of various thicknesses which were subjected to extreme conditions of 16 hour treatment at 1000°C followed by rapid cooling. Two sets of data were taken and plotted in Fig. 2, one set (solid line curves 2 and 3) representing wafer warpage prior to heat exposure and the other set (dashed line curves 2' and 3') representing wafer warpage subsequent to heating. The net warpage (the distance between the solid and dashed lines) due to heat treatment can be seen to reduce substantially to zero for wafers having thicknesses larger than 762 to 889 μm.

A simple, linear proportionality is believed to exist between optimum wafer thickness and wafer diameter, despite industry practice to minimize warpage seemingly to the contrary. As evidence of this, the plot of Fig. 3 has been prepared, using the above described data obtained from the 82.5 mm and 125 mm wafer diameter tests, together with data points representing pre-existing 31,75 and 57,15 mm diameter product wafers and representing one of two industry standard 102 mm diameter wafers, having thicknesses of 203, 381 and 635 μm, respectively. It readily can be observed from the plot of Fig. 3, that all of the optimum wafer thickness points, in accordance with the present invention, lie along the same straight line. This is in contrast with the prior art industry practice, represented by the curved plot, having generally lower wafer thickness values for given wafer diameter values.

FI 982 087

To avoid the need for wafer oxygen content monitoring to control warpage, as practiced in the art where 406 μm thick wafers of 82.5 mm diameter and 610 μm thick wafers of 125 mm diameter are used, wafer thicknesses of 533 μm and 813 μm, respectively, should be selected as shown in Fig. 3. It is understood that each of the thickness data points of Fig. 3 are subject to the normal wafer processing tolerance of ± 25 μm.

Fig. 4 is a plot of warpage spread data obtained from a number of wafers of the same 622 μm thickness having the indicated three different diameters of 82, 100 and 125 mm, respectively, after bipolar processing heat treatment. Plots 4, 5 and 6 represent 112, 39 and 82 wafers, respectively. The warpage spreads (represented by the vertical lengths of the plots) are good measures of warpage control and show a minimum when the deviation from the optimum thickness of Fig. 3 also is at a minimum. This is the case of the 100 mm diameter wafers whose thickness of 622 μm deviates only 4 % from the optimum thickness of 645 μm. The thickness deviations from the optimums of the 82.5 mm and 125 mm diameter wafers are 17 % and 23 %, respectively. Thus, when the wafer thickness is either two thin or too thick from the optimum thickness, the resulting warpage violates the warpage specification more frequently.

The most significant advantage of the optimum thickness discovery of the present invention is that it permits relief from the hazards of marginal wafer processing as when special processing conditions are relied upon to permit the use of wafers of non-optimum thickness. When optimum thickness is employed, the wafer is virtually immune to most conditions that produce warpage. Oxygen screening can be eliminated and other productivity enhancements can be realized.

FI 982 087

0137914

# C L A I M S

1. Silicon wafers for integrated circuit chip fabrication, which have diameters in excess of 55 mm and which are exposed to high temperature cycles during processing, characterized in that the thickness of the wafers is a function of the diameter, said function when plotted being determined by a straight line approximately defined by the points 82.5 mm diameter/533 μm thickness and 125 mm diameter/ 813 μm thickness, with a tolerance of about ± 25 μm.

2. Method of determining dimensions of silicon wafers as claimed in claim 1, characterized by using the function defined in claim 1.

FI 982 087

0137914

FIG. 1

FIG. 2

0137914

WAFER THICKNESS
(μm)

1000

800

600

400

200

INDUSTRY PRACTICE/STANDARD
(PRIOR ART)

**FIG. 3**

25    50    75    100    125    150    175    mm

WARPAGE (μm)

0

4

5

6

80    90    100    110    120    130    mm    WAFER DIAMETER

**FIG. 4**